# EUROPEAN PATENT SPECIFICATION

(11) **EP 2 844 611 B1**
(45) Date of publication and mention of the grant of the patent: **23.03.2016**
(21) Application number: 13715766.5
(22) Date of filing: 27.03.2013
(51) Int. Cl.: B81B 3/00

(54) **MEMS DEVICE**
MEMS-VORRICHTUNG
DISPOSITIF MEMS

(30) Priority: 27.03.2012 JP 2012071914
(43) Date of publication of application: 11.03.2015
(73) Proprietor: Kabushiki Kaisha Toyota Chuo Kenkyusho, Aichi-ken 480-1192 (JP)
(72) Inventor: OZAKI, Takashi, Aichi-ken 480-1192 (JP); FUJITSUKA, Norio, Aichi-ken 480-1192 (JP); SHIMAOKA, Keiichi, Aichi-ken 480-1192 (JP); NONOMURA, Yutaka, Aichi-ken 480-1192 (JP)
(74) Representative: Kramer Barske Schmidtchen Patentanwälte PartG mbB
(86) International application number: PCT/JP2013/002075
(87) International publication number: WO 2013/145735

(56) References cited:
- EP-A2- 1 518 822
- US-A1- 2002 118 472

## Description

### Technical Field

The present application relates to a MEMS (Micro Electro Mechanical Systems) device.

### Background Art

US 2002/0118472 A1 discloses a micromechanical apparatus including a microelectronic substrate and a tiltable body thereon. The tiltable body includes a plate configured to tilt about an axis parallel to the microelectronic substrate and a tilt stop engaging portion disposed axially adjacent the plate. A range of rotation of the plate about the axis is defined by contact of the tilt stop engaging portion with a tilt stop on the substrate. The microelectronic substrate may have an opening therein configured to receive the plate, and the tilt stop may include a surface of the microelectronic substrate adjacent the opening. An actuator, such as an electrostatic actuator, may tilt the tiltable body about the axis.

EP 1 518 822 A2 relates to various embodiments directed to various microdevices, including sensors, actuators, valves, scanning mirrors, accelerometers, switches and the like. In some embodiments the devices are formed via electrochemical fabrication. In particular, a microdevice comprises an electrostatically actuated micro-mirror scanning system comprising contoured electrodes that allow a reduced drive voltage without hindering mirror movement.

Japanese Patent Application Laid-open No. 2010-12574 discloses a MEMS device including a substrate, a tilting plate which is arranged at an interval from the substrate, a support member which is fixed to the substrate, and support beams which each have a first end connected to the support member, and a second end connected to the tilting plate, and tiltably support the tilting plate around a tilting axis. In this MEMS device, torque around the tilting axis is applied to the tilting plate by driving means, thereby allowing the tilting plate to tilt. A tilt angle of the tilting plate is defined by bringing an end of the tilting plate into contact with the substrate. This MEMS device can be used as a deflector by forming a reflective portion on the tilting plate.

### Summary of Invention

In the aforementioned MEMS device, when a warp in a direction along a tilting axis occurs on a tilting plate, a tilt angle is changed. Hereinafter, the change of a tilt angle in a case where a warp occurs in a direction along a tilting axis on a tilting plate in a conventional art will be described.

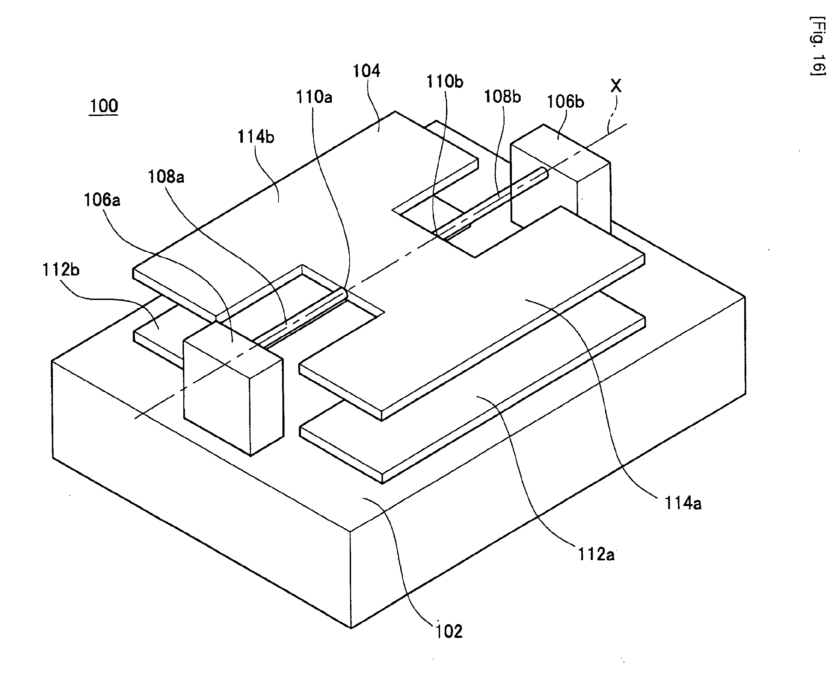

A light deflector 100 shown in FIG. 16 is a MEMS device of the conventional art, and includes a substrate 102, a tilting plate 104 arranged at an interval from the substrate 102, support columns 106a, 106b fixed to the substrate 102, and support beams 108a, 108b having first ends connected to the support columns 106a, 106b, and second ends connected to the tilting plate 104, and tiltably support the tilting plate 104 around a tilting axis X. The support beams 108a, 108b are connected to the tilting plate 104 at connecting portions 110a, 110b, respectively. The substrate 102 is formed with fixed electrode portions 112a, 112b. The tilting plate 104 is formed with movable electrode portions 114a, 114b. By applying a drive voltage between the fixed electrode portions 112a, 112b and the movable electrode portions 114a, 114b, torque around the tilting axis X acts on the tilting plate 104 due to electrostatic attractive force, and the tilting plate 104 tilts.

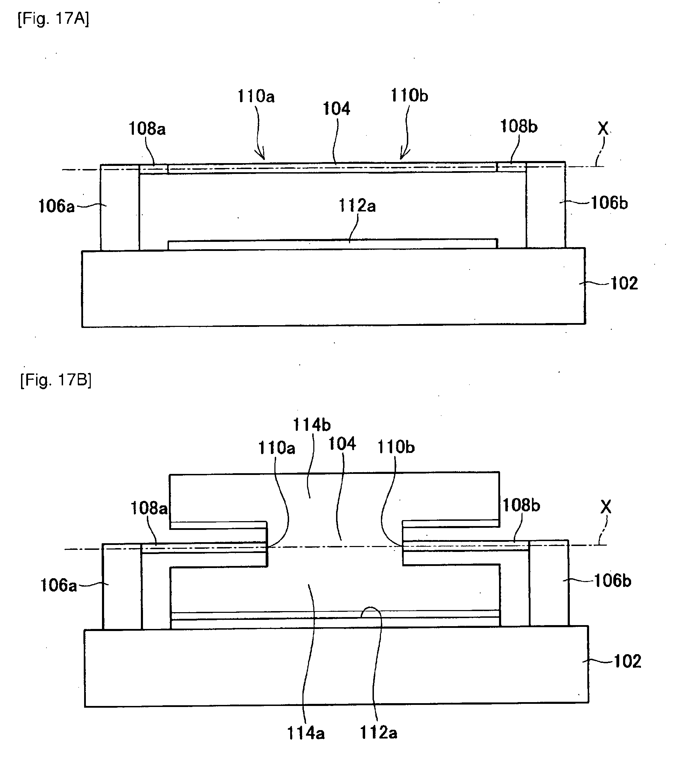

FIG. 17A and FIG. 17B show a tilting appearance of the tilting plate 104, which is an ideal state where a warp in a direction along the tilting axis X does not occur on the tilting plate 104. FIG. 17A shows a state where a drive voltage tilting the tilting plate 104 is not applied, and the tilting plate 104 is kept in such a state as to be substantially parallel to the substrate 102. FIG. 17B shows a state where a drive voltage is applied between the movable electrode portion 114a and the fixed electrode portion 112a, and the tilting plate 104 tilts. In this case, the tilting plate 104 tilts up to such a tilt angle that a side end portion of the movable electrode portion 114a comes into contact with the fixed electrode portion 112a.

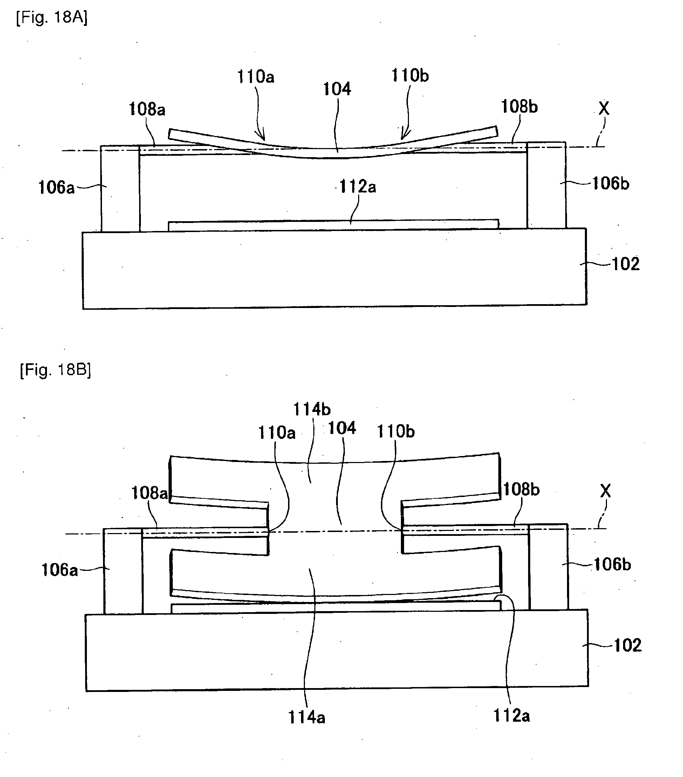

FIG. 18A and FIG. 18B show a tilting appearance of the tilting plate 104 in a case where the warp in the direction along the tilting axis X occurs on the tilting plate 104, and the tilting plate 104 is deformed in a downward convex shape. In this case, as shown in FIG. 18A, the tilting plate 104 sinks downward in a range inside the connecting portions 110a, 110b with the support beams 108a, 108b, and the tilting plate 104 rises upward in ranges outside the connecting portions 110a, 110b. Accordingly, as shown in FIG. 18B, when the drive voltage is applied between the movable electrode portion 114a and the fixed electrode portion 112a, and the tilting plate 104 tilts, a downwardly sinking portion of the movable electrode portion 114a comes into contact with the fixed electrode portion 112a earlier than other portions. A tilt angle in such a case is smaller than a tilt angle in the case where the warp does not occur on the tilting plate 104, shown in FIG. 17B.

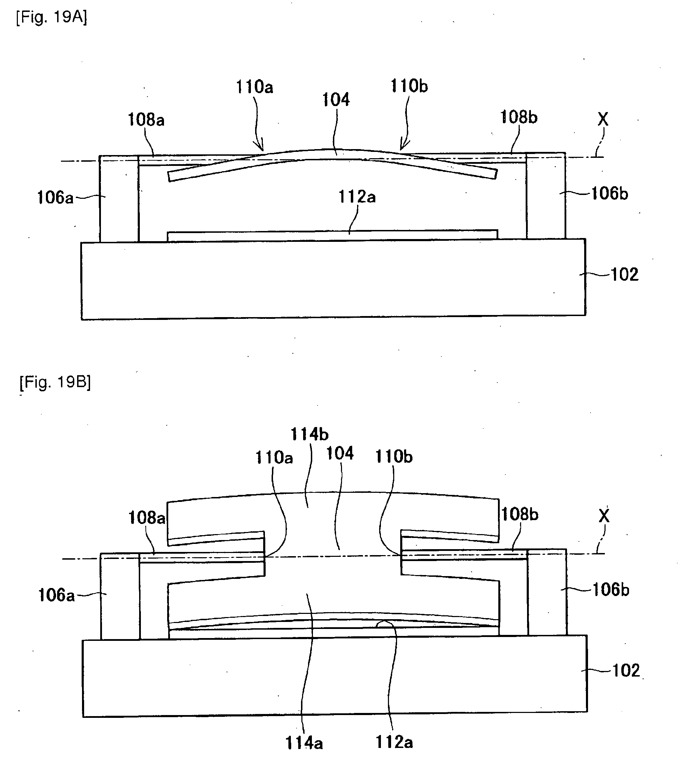

FIG. 19A and FIG. 19B show a tilting appearance of the tilting plate 104 in a case where the warp in the direction along the tilting axis X occurs on the tilting plate 104, and the tilting plate 104 is deformed in an upward convex shape. In this case, as shown in FIG. 19A, the tilting plate 104 rises upward in the range inside the connecting portions 110a, 110b with the support beams 108a, 108b, and the tilting plate 104 sinks downward in the ranges outside the connecting portions 110a, 110b. Accordingly, as shown in FIG. 19B, when the drive voltage is applied between the movable electrode portion 114a and the fixed electrode portion 112a, and the tilting plate 104 tilts, a downwardly sinking portion of the movable electrode portion 114a comes into contact with the fixed electrode portion 112a earlier than other portions. A tilt angle in such a case is smaller than the tilt angle in the case where the warp does not occur on the tilting plate 104, shown in FIG. 17B.

Generally, the MEMS device is easily influenced by a temperature environment to be used or residual strain at the time of manufacture, aged deterioration of quality, and the like, and a warp is likely to occur on a tilting plate. There is desired a technique capable of keeping a tilt angle constant even in a case where a warp in a direction along a tilting axis occurs on the tilting plate.

The present description provides a technique of solving the aforementioned problem. In the present description, there is provided a technique capable of keeping a tilt angle constant even in a case where a warp in a direction along a tilting axis occurs on a tilting plate in a MEMS device including the tilting plate tilting with respect to a substrate.

The present description discloses a MEMS device. The MEMS device includes a substrate, a tilting plate arranged at an interval from the substrate, a support member fixed to the substrate, and a support beam having a first end connected to the support member and a second end connected to the tilting plate, and tiltably supporting the tilting plate around a tilting axis. In the MEMS device, one of the substrate and the tilting plate is formed with a protruding portion. In the MEMS device, at least a part of the protruding portion is included in a plane perpendicular to the tilting axis, and including a connecting portion of the tilting plate and the support beam. In the MEMS device, the at least a part of the protruding portion comes into contact with the other of the substrate and the tilting plate, when the tilting plate tilts.

Even in a case where a warp in a direction along the tilting axis occurs on the tilting plate, the tilting plate does not rise upward or sink downward in the plane perpendicular to the tilting axis, and including the connecting portion of the tilting plate and the support beam. In the aforementioned MEMS device, the protruding portion is formed on the tilting plate or the substrate, such that such a portion as to be unaffected by the warp comes into contact with the substrate earlier than other portions. According to the aforementioned MEMS device, even in the case where the warp in the direction along the tilting axis occurs on the tilting plate, a tilt angle can be kept constant.

In the aforementioned MEMS device, the protruding portion can be performed by various aspects. For example, the protruding portion may be a tongue piece portion formed on the tilting plate, and extending in a direction perpendicular to the tilting axis from an end of the tilting plate toward outside. In this case, the tilting plate is preferably further formed with a projection portion extending from the tilting plate toward the substrate, in addition to the tongue piece portion, at least a part of the projection portion is preferably included in the plane perpendicular to the tilting axis, and including the connecting portion of the tilting plate and the support beam, and both of the at least a part of the tongue piece portion and the at least a part of the projection portion preferably come into contact with the substrate, when the tilting plate tilts. With such a configuration, it is possible to increase portions where the tilting plate and the substrate come into contact with each other when the tilting plate tilts, and to stabilize the tilt angle of the tilting plate even in a case where an excessive drive voltage is applied, or even in a case where disturbance vibration acts.

Alternatively, the protruding portion may be a projection portion formed on the tilting plate and extending from the tilting plate toward the substrate. Alternatively, the protruding portion may be a projection portion formed on the substrate and extending from the substrate toward the tilting plate.

In the aforementioned MEMS device, the tilting plate may have a laminated structure made of different materials. When the tilting plate has the laminated structure made of the different materials, the warp is likely to occur on the tilting plate due to a temperature environment to be used or residual strain at the time of manufacture, aged deterioration of quality, and the like, as compared with a case where the tilting plate has a single layer structure of the same material. According to the aforementioned MEMS device, even in a case of such a configuration, the tilt angle can be kept constant.

In the aforementioned MEMS device, the tilting plate may be formed in such a shape that a length in a direction along the tilting axis is longer than a length in a direction perpendicular to the tilting axis. When the tilting plate is formed so as to be long in the direction along the tilting axis, although torque for tilting the tilting plate can be reduced, the warp in the direction along the tilting axis is likely to occur on the tilting plate. According to the aforementioned MEMS device, even in a case of such a configuration, the tilt angle can be kept constant.

In the aforementioned MEMS device, the tilting plate can be configured so as to have a reflective portion. In this case, the reflective portion is preferably a minor capable of reflecting an electromagnetic wave. The MEMS device with such a configuration can be utilized as a light deflector with a stable reflection angle.

According to the technique disclosed in the present description, in a MEMS device including a tilting plate tilting with respect to a substrate, it is possible to keep a tilt angle constant even in a case where a warp in a direction along a tilting axis occurs on the tilting plate.

### Brief Description of Drawings

[fig.1]FIG. 1 is a perspective view showing a schematic configuration of a light deflector 10 according to a first embodiment.
[fig.2A]FIG. 2A is a figure showing a state where a warp in a direction along a tilting axis X does not occur on a tilting plate 18, and a drive voltage tilting the tilting plate 18 is not applied.
[fig.2B]FIG. 2B is a figure showing a state where the warp in the direction along the tilting axis X does not occur on the tilting plate 18, and the drive voltage tilting the tilting plate 18 is applied.
[fig.3A]FIG. 3A is a figure showing a state where the warp in the direction along the tilting axis X occurs on the tilting plate 18, and the tilting plate 18 is deformed in a downward convex shape, and the drive voltage tilting the tilting plate 18 is not applied.
[fig.3B]FIG. 3B is a figure showing a state where the warp in the direction along the tilting axis X occurs on the tilting plate 18, and the tilting plate 18 is deformed in the downward convex shape, and the drive voltage tilting the tilting plate 18 is applied.
[fig.4A]FIG. 4A is a figure showing a state where the warp in the direction along the tilting axis X occurs on the tilting plate 18, and the tilting plate 18 is deformed in an upward convex shape, and the drive voltage tilting the tilting plate 18 is not applied.
[fig.4B]FIG. 4B is a figure showing a state where the warp in the direction along the tilting axis X occurs on the tilting plate 18, and the tilting plate 18 is deformed in the upward convex shape, and the drive voltage tilting the tilting plate 18 is applied.
[fig.5]FIG. 5 is a figure showing an aspect of tongue piece portions 26a, 26b, 28a, 28b.
[fig.6]FIG. 6 is a figure showing another aspect of the tongue piece portions 26a, 26b, 28a, 28b.
[fig.7]FIG. 7 is a figure showing yet another aspect of the tongue piece portions 26a, 26b, 28a, 28b.
[fig.8]FIG. 8 is a perspective view showing a schematic configuration of a light deflector 30 according to a second embodiment.
[fig.9]FIG. 9 is a perspective view showing a schematic configuration of a light deflector 40 according to a third embodiment.
[fig.10]FIG. 10 is a perspective view showing a schematic configuration of a light deflector 50 according to a fourth embodiment.
[fig.11]FIG. 11 is a perspective view showing a schematic configuration of a light deflector 60 according to a fifth embodiment.
[fig.12]FIG. 12 is a figure showing an aspect of ribs 62a, 62b.
[fig.13]FIG. 13 is a figure showing another aspect of the ribs 62a, 62b.
[fig.14]FIG. 14 is a figure showing yet another aspect of the ribs 62a, 62b.
[fig.15]FIG. 15 is a figure showing further yet another aspect of the ribs 62a, 62b.
[fig. 16]FIG. 16 is a perspective view showing a schematic configuration of a light deflector 100 of a conventional art.
[fig.17A]FIG. 17A is a figure showing a state where a warp in a direction along a tilting axis X does not occur on a tilting plate 104, and a drive voltage tilting the tilting plate 104 is not applied.
[fig.17B]FIG. 17B is a figure showing a state where the warp in the direction along the tilting axis X does not occur on the tilting plate 104, and the drive voltage tilting the tilting plate 104 is applied.
[fig.18A]FIG. 18A is a figure showing a state where the warp in the direction along the tilting axis X occurs on the tilting plate 104, and the tilting plate 104 is deformed in a downward convex shape, and the drive voltage tilting the tilting plate 104 is not applied.
[fig.18B]FIG. 18B is a figure showing a state where the warp in the direction along the tilting axis X occurs on the tilting plate 104, and the tilting plate 104 is deformed in the downward convex shape, and the drive voltage tilting the tilting plate 104 is applied.
[fig.19A]FIG. 19A is a figure showing a state where the warp in the direction along the tilting axis X occurs on the tilting plate 104, and the tilting plate 104 is deformed in an upward convex shape, and the drive voltage tilting the tilting plate 104 is not applied.
[fig.19B]FIG. 19B is a figure showing a state where the warp in the direction along the tilting axis X occurs on the tilting plate 104, and the tilting plate 104 is deformed in the upward convex shape, and the drive voltage tilting the tilting plate 104 is applied.
[fig.20A]FIG. 20A is a longitudinal sectional view as viewed on a plane perpendicular to a tilting axis X, according to a modification of the light deflector 10 of the first embodiment, where the drive voltage tilting the tilting plate 18 is not applied.
[fig.20B]FIG. 20B is a longitudinal sectional view as viewed on the plane perpendicular to the tilting axis X, according to the modification of the light deflector 10 of the first embodiment, where the drive voltage tilting the tilting plate 18 is applied.

### Description of Embodiments

Preferred aspects of below embodiments will be listed.
1. A MEMS device is a light deflector provided with a mirror on a tilting plate.
2. Fixed electrodes are formed on a substrate, movable electrodes are formed on the tilting plate, and the tilting plate is tilted by applying a drive voltage between the fixed electrodes and the movable electrodes.

### (First Embodiment)

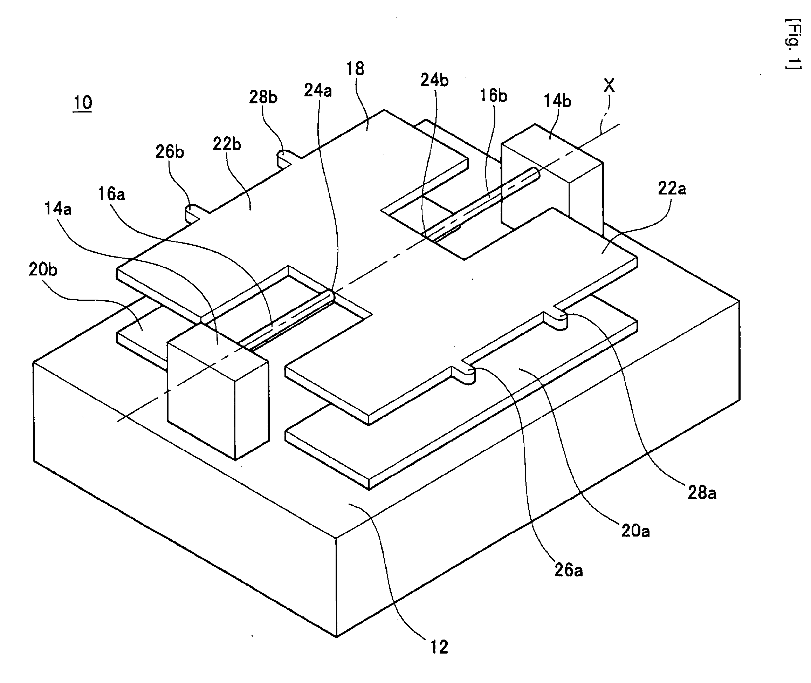

FIG. 1 shows a configuration of a light deflector 10 according to a first embodiment. The light deflector 10 includes a substrate 12, support columns 14a, 14b, support beams 16a, 16b, and a tilting plate 18. The light deflector 10 is a MEMS device manufactured by utilizing a semiconductor process.

The substrate 12 is formed on a silicon wafer. The substrate 12 includes fixed electrode portions 20a, 20b. The fixed electrode portions 20a, 20b include respective rectangular flat plate-like electrodes covered with insulating films. In the fixed electrode portions 20a, 20b of the present embodiment, polysilicon having a conductive property, which serves as an electrode, is covered with silicon oxide serving as an insulating film. The fixed electrode portions 20a, 20b are insulated from each other.

The support columns 14a, 14b are support members fixed to the substrate 12. The support columns 14a, 14b are arranged at positions opposed to each other so as to place the tilting plate 18 therebetween.

The support beam 16a connects between the support column 14a and the tilting plate 18. The support beam 16b connects between the support column 14b and the tilting plate 18. The tilting plate 18 is supported at two points from outside by the support beams 16a and the support beams 16b. The support beams 16a, 16b are each formed in an elongate shape such that rigidity with respect to torsion is reduced. When torque around a tilting axis X in a direction along the support beams 16a, 16b acts on the tilting plate 18, the support beams 16a, 16b supporting the tilting plate 18 are torsionally deformed, and the tilting plate 18 tilts around the tilting axis X.

The tilting plate 18 is a flat plate-like member having a laminated structure in which a periphery of a conductive layer is covered with an insulating layer. In the present embodiment, the conductive layer of the tilting plate 18 is polysilicon having a conductive property, and the insulating layer of the tilting plate 18 is silicon oxide. The tilting plate 18 is formed in such a shape that a length in the direction along the tilting axis X is longer than a length in a direction perpendicular to the tilting axis X. The tilting plate 18 is provided with movable electrode portions 22a, 22b. The movable electrode portion 22a is opposed to the fixed electrode portion 20a. The movable electrode portion 22b is opposed to the fixed electrode portion 20b. A reflective film (not shown) which serves as a mirror is formed on an upper surface of the tilting plate 18.

The tilting plate 18 is connected to the support beam 16a on a connecting portion 24a, and connected to the support beam 16b on a connecting portion 24b. The tilting plate 18 is formed with tongue piece, portions 26a, 26b in a plane including the connecting portion 24a and perpendicular to the tilting axis X. Additionally, the tilting plate 18 is formed with tongue piece portions 28a, 28b in a plane including the connecting portion 24b and perpendicular to the tilting axis X. The tongue piece portions 26a, 28a extend in the direction perpendicular to the tilting axis X from an end of the tilting plate 18 on a movable electrode portion 22a side toward outside. The tongue piece portions 26b, 28b extend in the direction perpendicular to the tilting axis X from an end of the tilting plate 18 on a movable electrode portion 22b side toward the outside. It can be said that the tongue piece portions 26a, 26b, 28a, 28b are protruding portions that first come into contact with the substrate 12 when the tilting plate 18 tilts.

The light deflector 10 is an electrostatically-driven light deflector, and tilts the tilting plate 18 by controlling a voltage applied to the fixed electrode portions 20a, 20b and the movable electrode portions 22a, 22b. The drive voltage applied to the fixed electrode portions 20a, 20b and the movable electrode portions 22a, 22b can be controlled by connecting the fixed electrode portions 20a, 20b and the movable electrode portions 22a, 22b to a drive signal generator (not shown) or the like.

For example, when the movable electrode portion 22a is a ground potential, and a drive voltage is applied to the fixed electrode portion 20a, electrostatic attractive force generates between the movable electrode portion 22a and the fixed electrode portion 20a, and the tilting plate 18 tilts in such a direction that the movable electrode portion 22a comes close to the fixed electrode portion 20a. In this case, the tilting plate 18 tilts up to such a tilt angle that the tongue piece portions 26a, 28a come into contact with the fixed electrode portion 20a. Unlike the above, when the movable electrode portion 22b is the ground potential, and the drive voltage is applied to the fixed electrode portion 20b, the electrostatic attractive force generates between the movable electrode portion 22b and the fixed electrode portion 20b, and the tilting plate 18 tilts in such a direction that the movable electrode portion 22b comes close to the fixed electrode portion 20b. In this case, the tilting plate 18 tilts up to such a tilt angle that the tongue piece portions 26b, 28b come into contact with the fixed electrode portion 20b.

A warp in the direction along the tilting axis X may occur on the tilting plate 18 due to a temperature environment to be used or residual strain at the time of manufacture, aged deterioration of quality, and the like. In a light deflector of a conventional art, when the warp in the direction along the tilting axis X occurs on the tilting plate 18, a distance between the tilting plate 18 and the substrate 12 becomes non-uniform, a tilt angle may be changed. However, in the light deflector 10 according to the present embodiment, it is possible to keep the tilt angle of the tilting plate 18 constant even in a case where the warp in the direction along the tilting axis X occurs on the tilting plate 18.

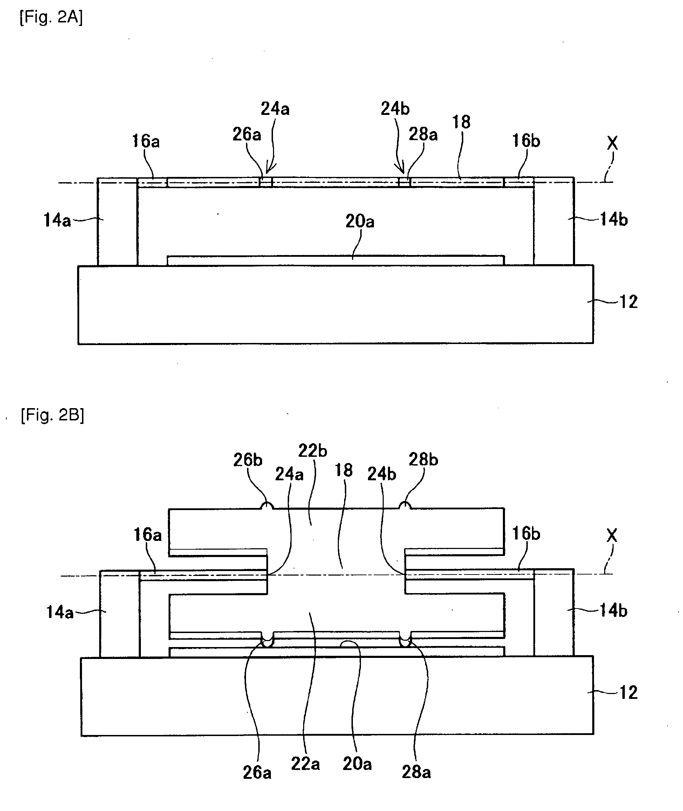

FIG. 2A and FIG. 2B show a tilting appearance of the tilting plate 18 in an ideal state where the warp in the direction along the tilting axis X does not occur on the tilting plate 18. FIG. 2A shows a state where the drive voltage tilting the tilting plate 18 is not applied, and the tilting plate 18 is kept in such a state as to be substantially parallel to the substrate 12. FIG. 2B shows a state where the drive voltage is applied between the movable electrode portion 22a and the fixed electrode portion 20a, and the tilting plate 18 tilts. In this case, the tilting plate 18 tilts up to such a tilt angle that the tongue piece portions 26a, 28a come into contact with the fixed electrode portion 20a.

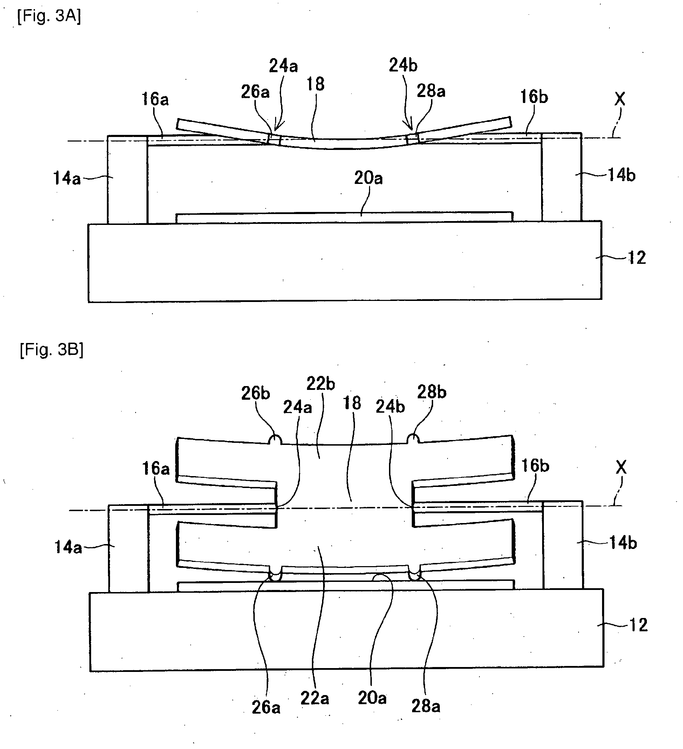

FIG. 3A and FIG.3B show a tilting appearance of the tilting plate 18 in a case where the warp in the direction along the tilting axis X occurs on the tilting plate 18, and the tilting plate 18 is deformed in a downward convex shape. In this case, as shown in FIG. 3A, the tilting plate 18 sinks downward in a range inside the connecting portions 24a, 24b with the support beams 16a, 16b, and the tilting plate 18 rises upward in ranges outside the connecting portions 24a, 24b. However, the tongue piece portions 26a, 26b, 28a, 28b are formed in a plane including the connecting portions 24a, 24b and perpendicular to the tilting axis X, and hence a position from the tilting axis X is not changed even when the warp in the direction along the tilting axis X occurs on the tilting plate 18. Accordingly, as shown in FIG. 3B, a tilt angle in the case where the voltage is applied between the movable electrode portion 22a and the fixed electrode portion 20a, and the tilting plate 18 tilts is the same as a tilt angle in the case where the warp does not occurs on the tilting plate 18, shown in FIG. 2B.

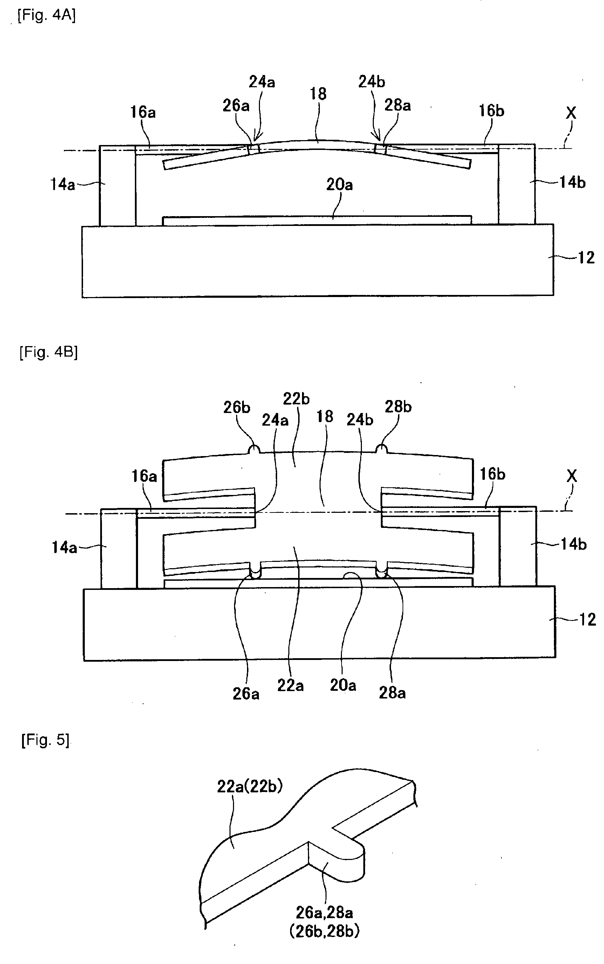

FIG. 4A and FIG. 4B shows a tilting appearance of the tilting plate 18 in a case where the warp in the direction along the tilting axis X occurs on the tilting plate 18, and the tilting plate 18 is deformed in an upward convex shape. In this case, as shown in FIG. 4A, the tilting plate 18 rises upward in the range inside the connecting portions 24a, 24b with the support beams 16a, 16b, and the tilting plate 18 sinks downward in the ranges outside the connecting portions 24a, 24b. However, the tongue piece portions 26a, 26b, 28a, 28b are formed in the plane including the connecting portions 24a, 24b and perpendicular to the tilting axis X, and hence a position from the tilting axis X is not changed even when the warp in the direction along the tilting axis X occurs on the tilting plate 18. Accordingly, as shown in FIG. 4B, a tilt angle in the case where the voltage is applied between the movable electrode portion 22a and the fixed electrode portion 20a, and the tilting plate 18 tilts is the same as a tilt angle in the case where the warp does not occurs on the tilting plate 18, shown in FIG. 2B.

As described above, according to the light deflector 10 of the present embodiment, even in the case where the warp in the direction along the tilting axis X occurs on the tilting plate 18, the tilt angle of the tilting plate 18 is not changed. It is possible to keep the tilt angle of the tilting plate 18 constant even in the case where the warp in the direction along the tilting axis X occurs on the tilting plate 18 due to a temperature environment to be used or residual strain at the time of manufacture, aged deterioration of quality, and the like.

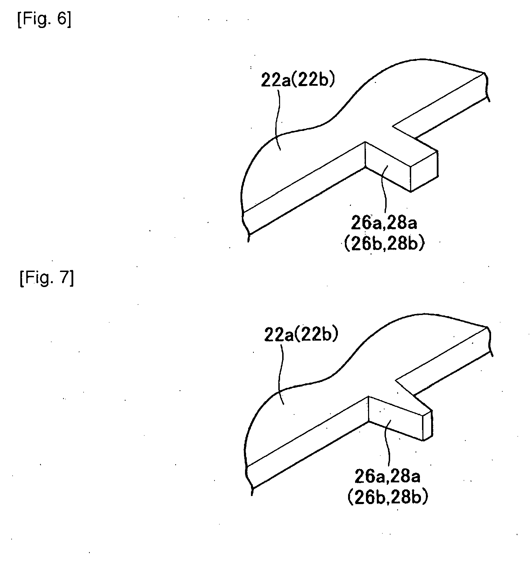

The tongue piece portions 26a, 26b, 28a, 28b may be formed in various shapes. For example, as shown in FIG. 5, the shape may be a shape formed by combining a semicircle and a rectangle, a shape formed in a rectangle as a whole as shown FIG. 6, or a trapezoid as shown in FIG. 7.

In the light deflector 10 of the present embodiment, when the warp in the direction along the tilting axis X occurs on the tilting plate 18, bending slightly acts on the support beams 16a, 16b, and the tilt angle of the tilting plate 18 is slightly changed due to this bending deformation of the support beams 16a, 16b. In order to eliminate this influence, the light deflector 10 is preferably manufactured such that tension is previously applied to the support beams 16a, 16b. It is possible to suppress the bending deformation of the support beams 16a, 16b, and keep the tilt angle of the tilting plate 18 constant by applying tension to the support beams 16a, 16b, even in the case where the warp in the direction along the tilting axis X occurs on the tilting plate 18.

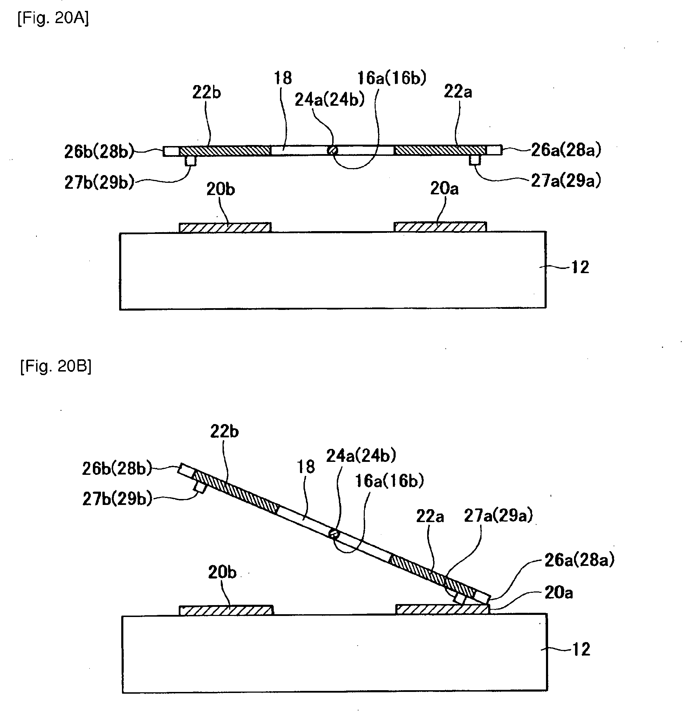

In the light deflector 10 of the present embodiment, as shown in FIG. 20A, projection portions 27a, 27b, 29a, 29b may be provided on a lower surface of the tilting plate 18. The projection portions 27a, 27b are formed in a plane including the connecting portion 24a of the tilting plate 18 and the support beam 16a and perpendicular to the tilting axis X. The projection portions 29a, 29b are formed in a plane including the connecting portion 24b of the tilting plate 18 and the support beam 16b and perpendicular to the tilting axis X. A protrusion amount of each of the projection portions 27a, 29a from the tilting plate 18 is set such that the projection portions 27a, 29a come into contact with the substrate 12 at the same time as the tongue piece portions 26a, 28a when the tilting plate 18 tilts, as shown in FIG. 20B. A protrusion amount of each of the projection portions 27b, 29b from the tilting plate 18 is set such that the projection portions 27b, 29b come into contact with the substrate 12 at the same time as the tongue piece portions 26b, 28b when the tilting plate 18 tilts. With such a structure, it is possible to increase portions where the tilting plate 18 and the substrate 12 come into contact with each other when the tilting plate 18 tilts, and to stabilize the tilt angle of the tilting plate 18 even in a case where an excessive drive voltage is applied, or even in a case where disturbance vibration acts.

### (Second Embodiment)

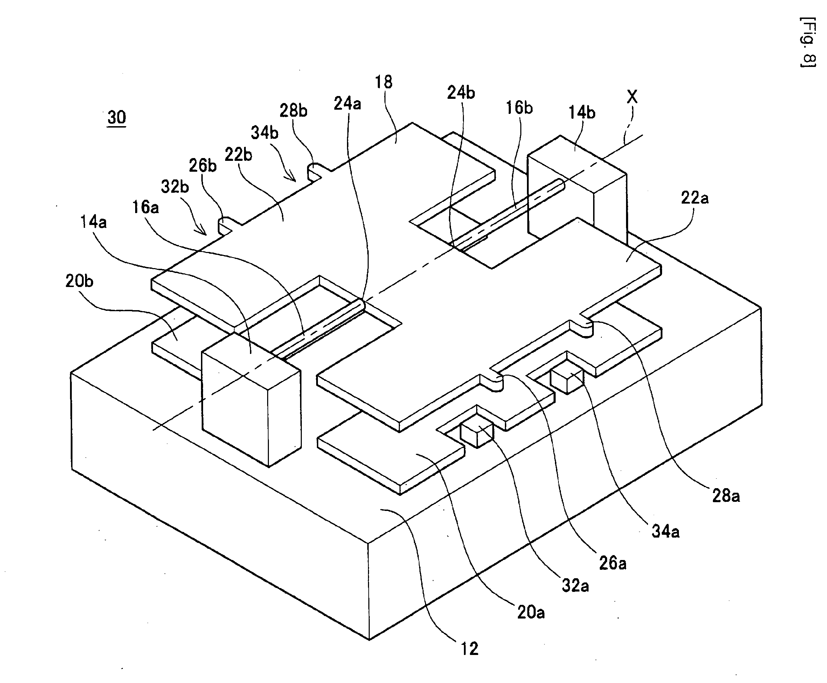

FIG. 8 shows a configuration of a light deflector 30 according to a second embodiment. The light deflector 30 of the present embodiment includes a configuration substantially similar to that of the light deflector 10 of the first embodiment. Hereinafter, configuration components similar to those of the first embodiment are denoted by the same reference numerals, and detailed description thereof will be omitted.

In the light deflector 30 of the present embodiment, a substrate 12 is formed with auxiliary electrode portions 32a, 32b, 34a, 34b in addition to fixed electrode portions 20a, 20b. The auxiliary electrode portions 32a, 32b, 34a, 34b are arranged at respective positions where tongue piece portions 26a, 26b, 28a, 28b come into contact with the substrate 12 when a tilting plate 18 tilts. The auxiliary electrode portions 32a, 32b, 34a, 34b each include an electrode covered with an insulating film. In the auxiliary electrode portions 32a, 32b, 34a, 34b of the present embodiment, polysilicon having a conductive property, which serves as an electrode, is covered with silicon oxide serving as an insulating film. The auxiliary electrode portions 32a, 32b, 34a, 34b are insulated from the fixed electrode portions 20a, 20b. In the present embodiment, the fixed electrode portions 20a, 20b are each formed in a partially notched shape so as not to interfere with the auxiliary electrode portions 32a, 32b, 34a, 34b. The auxiliary electrode portions 32a, 32b, 34a, 34b are formed so as to be higher than the fixed electrode portions 20a, 20b. In other words, the auxiliary electrode portions 32a, 32b, 34a, 34b are each formed in such a shape as to protrude toward the tilting plate 18 with respect to the fixed electrode portions 20a, 20b. The auxiliary electrode portions 32a, 34a are maintained at the same potential as a movable electrode portion 22a by wiring (not shown). The auxiliary electrode portions 32b, 34b are maintained at the same potential as a movable electrode portion 22b by wiring (not shown).

In the light deflector 30 of the present embodiment, when a drive voltage is applied between the fixed electrode portion 20a and the movable electrode portion 22a, the tilting plate 18 tilts up to such a tilt angle that the tongue piece portions 26a, 28a come into contact with the auxiliary electrode portions 32a, 34a. At this time, since potentials of the tongue piece portions 26a, 28a and the auxiliary electrode portions 32a, 34a are kept at the same level, charge trapping or a short circuit at contact portions does not occur. Additionally, in the light deflector 30 of the present embodiment, when a drive voltage is applied between the fixed electrode portion 20b and the movable electrode portion 22b, the tilting plate 18 tilts up to such a tilt angle that the tongue piece portions 26b, 28b come into contact with the auxiliary electrode portions 32b, 34b. At this time, since potentials of the tongue piece portions 26b, 28b and the auxiliary electrode portions 32b, 34b are kept at the same level, charge trapping or a short circuit at contact portions does not occur. In the light deflector 30 of the present embodiment, stability of operation can be enhanced.

### (Third Embodiment)

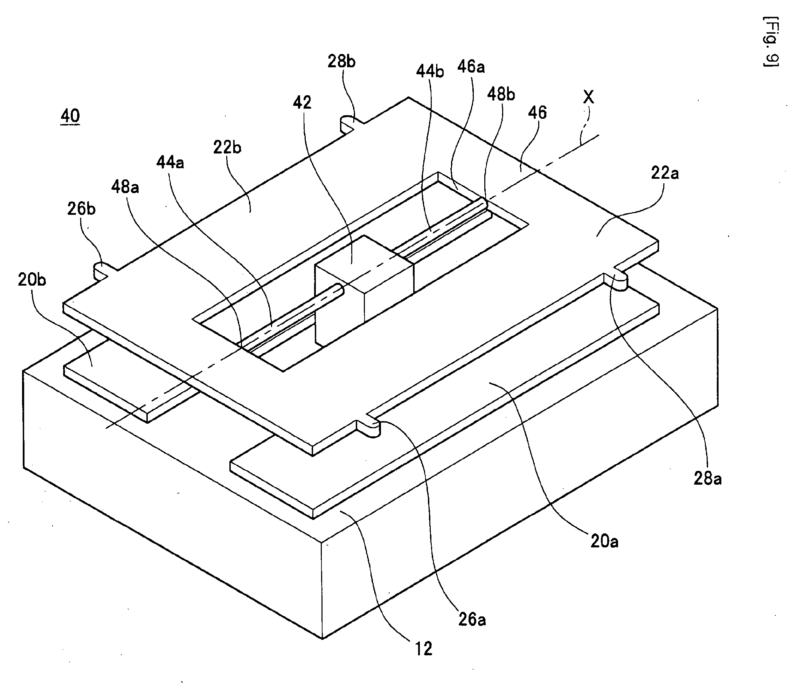

FIG. 9 shows a configuration of a light deflector 40 according to a third embodiment. Hereinafter, configuration components similar to those of the first embodiment are denoted by the same reference numerals, and detailed description thereof will be omitted. The light deflector 40 includes a substrate 12, a support column 42, support beams 44a, 44b, and a tilting plate 46. The light deflector 40 is a MEMS device manufactured by utilizing a semiconductor process.

The support column 42 is a support member fixed to the substrate 12. The support column 42 is arranged at a position of a center of an opening 46a formed in a center of the tilting plate 46.

The support beams 44a, 44b are connected between the support column 42 and the tilting plate 46. The support beams 44a, 44b are arranged at such symmetric positions so as to hold a support column 42 therebetween. The tilting plate 46 is supported at two points from inside by the support beam 44a and the support beam 44b. The support beams 44a, 44b are each formed in an elongate shape such that rigidity with respect to torsion is reduced. When torque around a tilting axis X in a direction along the support beams 44a, 44b acts on the tilting plate 46, the support beams 44a, 44b supporting the tilting plate 46 are torsionally deformed, and the tilting plate 46 tilts around the tilting axis X.

The tilting plate 46 is a flat plate-like member having a laminated structure where a periphery of a conductive layer is covered with an insulating layer. In the present embodiment, the conductive layer of the tilting plate 46 is polysilicon having a conductive property, and the insulating layer of the tilting plate 46 is silicon oxide. The tilting plate 46 is formed in such a shape that a length in the direction along the tilting axis X is longer than a length in a direction perpendicular to the tilting axis X. The tilting plate 46 is formed with movable electrode portions 22a, 22b. The movable electrode portion 22a is opposed to a fixed electrode portion 20a formed on the substrate 12. The movable electrode portion 22b is opposed to a fixed electrode portion 20b formed on the substrate 12. A reflective film (not shown) which serves as a mirror is formed on an upper surface of the tilting plate 46.

The tilting plate 46 is connected to the support beam 44a on a connecting portion 48a, and connected to the support beam 44b on a connecting portion 48b. The tilting plate 46 is formed with tongue piece portions 26a, 26b in a plane including the connecting portion 48a and perpendicular to the tilting axis X. Additionally, the tilting plate 46 is formed with tongue piece portions 28a, 28b in a plane including the connecting portion 48b and perpendicular to the tilting axis X. The tongue piece portions 26a, 28a extend in the direction perpendicular to the tilting axis X from an end of the tilting plate 46 on a movable electrode portion 22a side toward outside. The tongue piece portions 26b, 28b extend in the direction perpendicular to the tilting axis X from an end of the tilting plate 46 on a movable electrode portion 22b side toward the outside. It can be said that the tongue piece portions 26a, 26b, 28a, 28b are protruding portions that first come into contact with the substrate 12 when the tilting plate 46 tilts.

As in the present embodiment, also in a case where the tilting plate 46 is supported at the two points by the support beams 44a, 44b and the support column 42 arranged inside the tilting plate 46, positions of the tongue piece portions 26a, 26b, 28a, 28b from the tilting axis X are not changed when a warp in the direction along the tilting axis X occurs on the tilting plate 46. Accordingly, even in a case where the warp in the direction along the tilting axis X occurs on the tilting plate 46, a tilt angle of the tilting plate 46 is not changed. It is possible to keep the tilt angle of the tilting plate 46 constant even in the case where the warp in the direction along the tilting axis X occurs on the tilting plate 46 due to a temperature environment to be used or residual strain at the time of manufacture, aged deterioration of quality, and the like.

### (Fourth Embodiment)

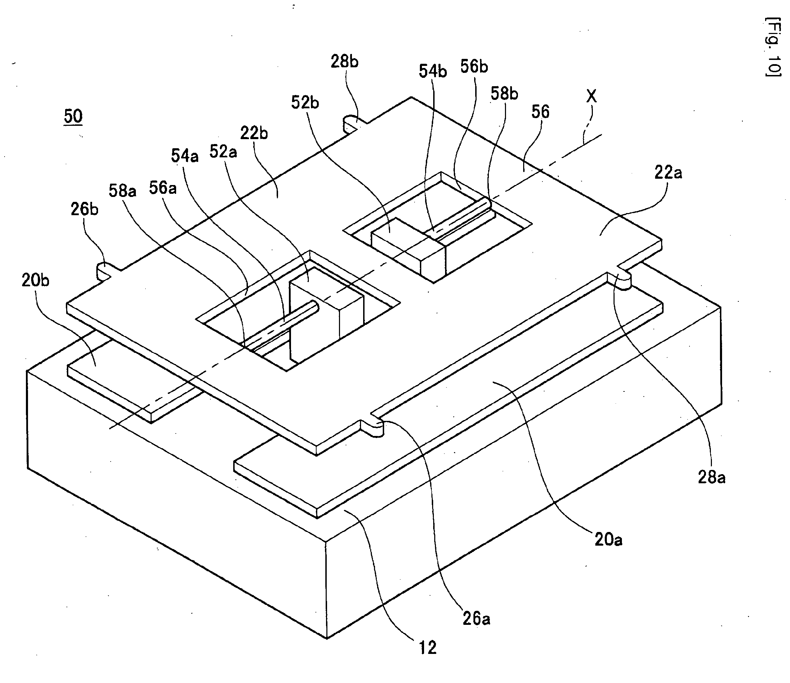

FIG. 10 shows a configuration of a light deflector 50 according to a fourth embodiment. Hereinafter, configuration components similar to those of the first embodiment are denoted by the same reference numerals, and detailed description thereof will be omitted. The light deflector 50 includes a substrate 12, support columns 52a, 52b, support beams 54a, 54b, and a tilting plate 56. The light deflector 50 is a MEMS device manufactured by utilizing a semiconductor process.

The support columns 52a, 52b are support members fixed to the substrate 12. The support columns 52a, 52b are arranged at positions inside openings 56a, 56b formed in the tilting plate 56.

The support beam 54a is connected between the support column 52a and the tilting plate 56. The support beam 54b is connected between the support column 52b and the tilting plate 56. The support column 52a and the support beam 54a, and the support column 52b and the support beam 54b are arranged at such symmetrical positions so as to place a center of the tilting plate 56 therebetween in plan view of the tilting plate 56 from above. The tilting plate 56 is supported by two points from inside by the support beam 54a and the support beam 54b. The support beams 54a, 54b are each formed in an elongate shape such that rigidity with respect to torsion is reduced. When torque around a tilting axis X in a direction along the support beams 54a, 54b acts on the tilting plate 56, the support beams 54a, 54b supporting the tilting plate 56 are torsionally deformed, and the tilting plate 56 tilts around the tilting axis X.

The tilting plate 56 is a flat plate-like member having a laminated structure where a periphery of a conductive layer is covered with an insulating layer. In the present embodiment, the conductive layer of the tilting plate 56 is polysilicon having a conductive property, the insulating layer of the tilting plate 56 is silicon oxide. The tilting plate 56 is formed in such a shape that a length in the direction along the tilting axis X is longer than a length in a direction perpendicular to the tilting axis X. The tilting plate 56 is formed with movable electrode portions 22a, 22b. The movable electrode portion 22a is opposed to a fixed electrode portion 20a formed on the substrate 12. The movable electrode portion 22b is opposed to a fixed electrode portion 20b formed on the substrate 12. A reflective film (not shown) which serves as a mirror is formed on an upper surface of the tilting plate 56.

The tilting plate 56 is connected to the support beam 54a on a connecting portion 58a, and connected to the support beam 54b on a connecting portion 58b. The tilting plate 56 is formed with tongue piece portions 26a, 26b in a plane including the connecting portion 58a and perpendicular to the tilting axis X. Additionally, the tilting plate 56 is formed with tongue piece portions 28a, 28b in a plane including the connecting portion 58b and perpendicular to the tilting axis X. The tongue piece portions 26a, 28a extend in the direction perpendicular to the tilting axis X from an end of the tilting plate 56 on a movable electrode portion 22a side toward outside. The tongue piece portions 26b, 28b extend in the direction perpendicular to the tilting axis X from an end of the tilting plate 56 on a movable electrode portion 22b side toward the outside. It can be said that the tongue piece portions 26a, 26b, 28a, 28b are protruding portions that first come into contact with the substrate 12 when the tilting plate 56 tilts.

As in the present embodiment, also in a case where the tilting plate 56 is supported at the two points by the support beams 54a, 54b and the support columns 52a, 52b arranged inside the tilting plate 56, positions of the tongue piece portions 26a, 26b, 28a, 28b from the tilting axis X are not changed even when a warp in the direction along the tilting axis X occurs on the tilting plate 56. Accordingly, even in a case where the warp in the direction along the tilting axis X occurs on the tilting plate 56, a tilt angle of the tilting plate 56 is not changed. It is possible to keep the tilt angle of the tilting plate 56 constant even in the case where the warp in the direction along the tilting axis X occurs on the tilting plate 56 due to a temperature environment to be used or residual strain at the time of manufacture, aged deterioration of quality, and the like.

### (Fifth Embodiment)

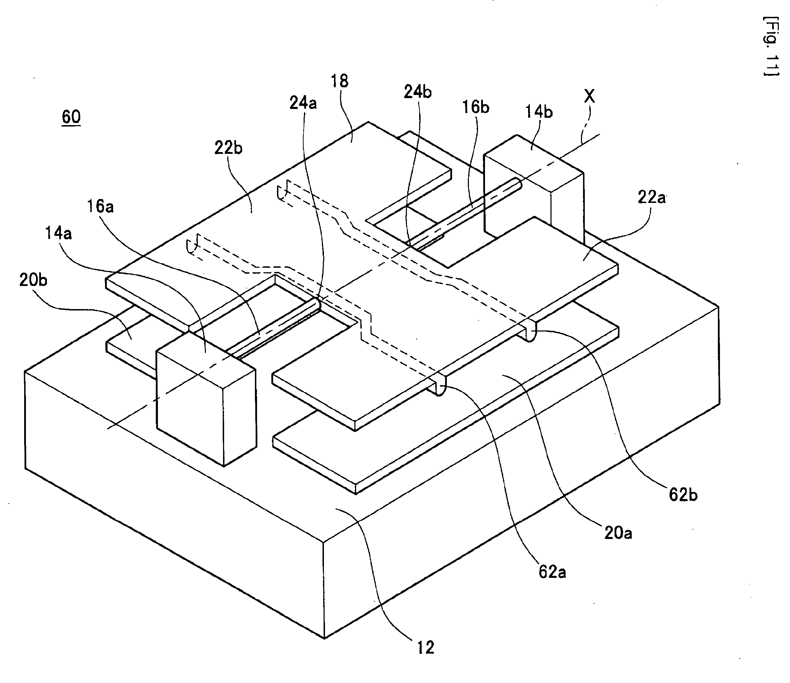

FIG. 11 shows a configuration of a light deflector 60 according to a fifth embodiment. The light deflector 60 of the present embodiment includes a configuration substantially similar to that of the light deflector 10 of the first embodiment. Hereinafter, configuration components similar to those of the first embodiment are denoted by the same reference numerals, and detailed description thereof will be omitted.

In the light deflector 60 of the present embodiment, a tilting plate 18 is formed with ribs 62a, 62b in place of tongue piece portions 26a, 26b, 28a, 28b. It can be said that the ribs 62a, 62b are protruding portions extending from the tilting plate 18 toward a substrate 12. The ribs 62a, 62b are formed on the tilting plate 18 along a direction perpendicular to a tilting axis X. By the ribs 62a, 62b, rigidity of the tilting plate 18 in the direction perpendicular to the tilting axis X is improved, and occurrence of a warp in the direction perpendicular to the tilting axis X of the tilting plate 18 is suppressed. The rib 62a is arranged in a plane, which includes a connecting portion 24a of the tilting plate 18 and a support beam 16a and is perpendicular to the tilting axis X, on an end of the tilting plate 18 on a movable electrode portion 22a side and an end of the tilting plate 18 on a movable electrode portion 22b side. The rib 62b is arranged in a plane, which includes a connecting portion 24b of the tilting plate 18 and a support beam 16b and is perpendicular to the tilting axis X, on the end of the tilting plate 18 on the movable electrode portion 22a side and the end of the tilting plate 18 on the movable electrode portion 22b side. It can be said that the ribs 62a, 62b are protruding portions that first come into contact with the substrate 12 when the tilting plate 18 tilts.

Similarly to the tongue piece portions 26a, 26b, 28a, 28b of the first embodiment, even when the warp in the direction along the tilting axis X occurs on the tilting plate 18, positions of the ribs 62a, 62b of the present embodiment from the tilting axis X are not changed on the ends of the movable electrode portion 22a side and the end on the movable electrode portion 22b side. Accordingly, even when the warp in the direction along the tilting axis X occurs on the tilting plate 18, a tilt angle of the tilting plate 18 is not changed. It is possible to keep the tilt angle of the tilting plate 18 constant even in the case where the warp in the direction along the tilting axis X occurs on the tilting plate 18 due to a temperature environment to be used or residual strain at the time of manufacture, aged deterioration of quality, and the like.

As long as the ribs 62a, 62b are formed at least on the end of the tilting plate 18 on the movable electrode portion 22a side and the end of the tilting plate 18 on the movable electrode portion 22b side, the ribs 62a, 62b do not always have to be formed so as to cross a whole of the tilting plate 18. Additionally, as to places other than the end of the tilting plate 18 on the movable electrode portion 22a side and the end of the tilting plate 18 on the movable electrode portion 22b side, other kinds of ribs (e.g., ribs extending along the tilting axis X) may be formed on the tilting plate 18.

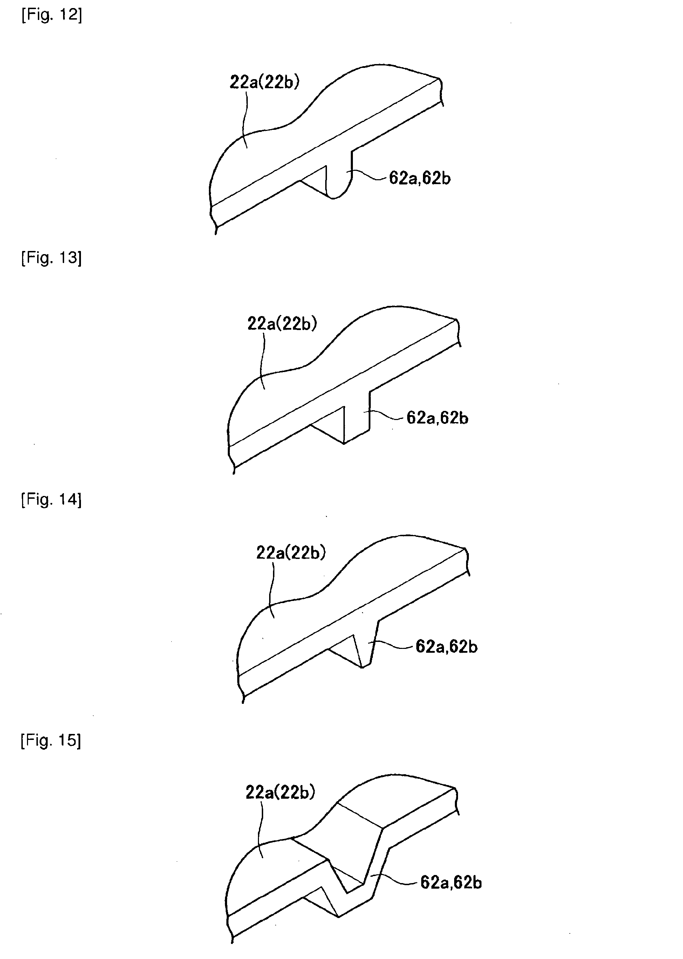

For a cross-sectional shape of each of the ribs 62a, 62b, various shapes may be employed. For example, the shape may be a cross-sectional shape formed by combining a semicircle and a rectangle as shown in FIG. 12, a shape formed in rectangular cross-sectional shape as shown FIG. 13, or a trapezoidal cross-sectional shape as shown in FIG. 14. Alternatively, the ribs 62a, 62b may be formed by bending the movable electrode portions 22a, 22b of the tilting plate 18 in a wavelike manner as shown in FIG. 15.

Although the embodiments of the present invention have been described in detail, these are merely exemplary of the invention and do not limit the scope of the present invention. A technique recited in the clams includes various modifications and changes of the embodiments illustrated above.

Although the light deflector reflecting visible light is described in the aforementioned embodiment, a deflector reflecting any energy lines such as ultraviolet rays, infrared rays, electromagnetic waves such as microwaves, and electron beams can be achieved by using a member capable of reflecting the energy lines as a reflective film in place of a mirror reflecting visible light.

Although the tilting plate is tilted by a so-called electrostatic drive system, in which the substrate is formed with the fixed electrodes, and the tilting plate is formed with the movable electrode, in the aforementioned embodiment, the drive system which tilts the tilting plate is not limited to this. For example, the tilting plate may be tilted by placing a permanent magnet on one of the substrate and the tilting plate, placing a coil on the other thereof, and utilizing magnetic force generated by energization to the coil.

Technical elements described in the present description or drawings exert technical utility independently or in various combinations, and are not limited to combinations recited in original claims. Furthermore, the technique illustrated in the present description or drawings simultaneously attains a plurality of purposes, and has the technical utility by attaining one of these purposes.

## Claims

1. A MEMS device (10; 30; 40; 50; 60) comprising:
a substrate (12);
a tilting plate (18; 46; 56) arranged at an interval from the substrate (12);
a support member (14a, 14b; 42; 52a, 52b) fixed to the substrate (12); and
a support beam (16a, 16b; 44a, 44b; 54a, 54b) having a first end connected to the support member (14a, 14b; 42; 52a, 52b) and a second end connected to the tilting plate (18; 46; 56), and tiltably supporting the tilting plate (18; 46; 56) around a tilting axis (X), wherein one of the substrate (12) and the tilting plate (18; 46; 56) is formed with a protruding portion (26a, 26b, 27a, 27b, 28a, 28b, 29a, 29b, 32a, 32b, 34a, 34b; 62a, 62b),
at least a part of the protruding portion (26a, 26b, 27a, 27b, 28a, 28b, 29a, 29b, 32a, 32b, 34a, 34b; 62a, 62b) is included in a plane perpendicular to the tilting axis (X), and including a connecting portion (24a, 24b; 48a, 48b; 58a, 58b) of the tilting plate (18; 46; 56) and the support beam (16a, 16b; 44a, 44b; 54a, 54b),
with respect to a direction along the tilting axis (X), a side end portion of the tilting plate (18; 46; 56) extends beyond the connecting portion (24a, 24b; 48a, 48b; 58a, 58b) of the tilting plate (18; 46; 56) and the support beam (16a, 16b; 44a, 44b; 54a, 54b) to a support member (14a, 14b; 42; 52a, 52b) side, and
the at least a part of the protruding portion (26a, 26b, 27a, 27b, 28a, 28b, 29a, 29b, 32a, 32b, 34a, 34b; 62a, 62b) comes into contact with the other of the substrate (12) and the tilting plate (18; 46; 56), when the tilting plate (18; 46; 56) tilts.

2. The MEMS device (10; 30; 40; 50) according to claim 1, wherein
the protruding portion (26a, 26b, 28a, 28b) is a tongue piece portion formed on the tilting plate (18; 46; 56), and extending in a direction perpendicular to the tilting axis (X) from an end of the tilting plate (18; 46; 56) toward outside.

3. The MEMS device (10) according to claim 2, wherein
the tilting plate (18) is further formed with a projection portion (27a, 27b, 29a, 29b) extending from the tilting plate (18) toward the substrate (12), in addition to the tongue piece portion (26a, 26b, 28a, 28b),
at least a part of the projection portion (27a, 27b, 29a, 29b) is included in the plane perpendicular to the tilting axis (X), and including the connecting portion (24a, 24b) of the tilting plate (18) and the support beam (16a, 16b), and
both of the at least a part of the tongue piece portion (26a, 26b, 28a, 28b) and the at least a part of the projection portion (27a, 27b, 29a, 29b) come into contact with the substrate (12), when the tilting plate (18) tilts.

4. The MEMS device (60) according to claim 1, wherein
the protruding portion (62a, 62b) is a projection portion formed on the tilting plate (18) and extending from the tilting plate (18) toward the substrate (12).

5. The MEMS device (30) according to claim 1, wherein
the protruding portion (32a, 32b, 34a, 34b) is a projection portion formed on the substrate (12) and extending from the substrate (12) toward the tilting plate (18).

6. The MEMS device (10; 30; 40; 50; 60) according to any one of claims 1 to 5, wherein the tilting plate (18; 46; 56) has a laminated structure made of different materials.

7. The MEMS device (10; 30; 40; 50; 60) according to any one of claims 1 to 6, wherein the tilting plate (18; 46; 56) is formed in such a shape that a length in a direction along the tilting axis (X) is longer than a length in a direction perpendicular to the tilting axis (X).

8. The MEMS device (10; 30; 40; 50; 60) according to any one of claims 1 to 7, wherein the tilting plate (18; 46; 56) has a reflective portion.

9. The MEMS device (10; 30; 40; 50; 60) according to claim 8, wherein
the reflective portion is a mirror capable of reflecting an electromagnetic wave.

## Patentansprüche

1. MEMS-Vorrichtung (10; 30; 40; 50; 60) mit:
einem Substrat (12);
einer Kippplatte (18; 46; 56), die in einem Abstand zu dem Substrat (12) angeordnet ist;
einem Tragbauteil (14a, 14b; 42; 52a, 52b), das an dem Substrat (12) befestigt ist; und
einem Tragbalken (16a, 16b; 44a, 44b; 54a, 54b), der ein erstes Ende, das mit dem Tragbauteil (14a, 14b; 42; 52a, 52b) verbunden ist, und ein zweites Ende, das mit der Kippplatte (18; 46; 56) verbunden ist, aufweist und die Kippplatte (18; 46; 56) kippbar um eine Kippachse (X) trägt, wobei
eines von dem Substrat (12) und der Kippplatte (18; 46; 56) mit einem vorstehenden Abschnitt (26a, 26b, 27a, 27b, 28a, 28b, 29a, 29b, 32a, 32b, 34a, 34b; 62a, 62b) ausgebildet ist,
mindestens ein Teil des vorstehenden Abschnitts (26a, 26b, 27a, 27b, 28a, 28b, 29a, 29b, 32a, 32b, 34a, 34b; 62a, 62b) in einer Ebene enthalten ist, die senkrecht zu der Kippachse (X) ist und einen Verbindungsabschnitt (24a, 24b; 48a, 48b; 58a, 58b) der Kippplatte (18; 46; 56) und des Tragbalkens (16a, 16b; 44a, 44b; 54a, 54b) enthält,
in Bezug auf eine Richtung längs der Kippachse (X), sich ein seitlicher Endabschnitt der Kippplatte (18; 46; 56) über den Verbindungsabschnitt (24a, 24b; 48a, 48b; 58a, 58b) der Kippplatte (18; 46; 56) und des Tragbalkens (16a, 16b; 44a, 44b; 54a; 54b) hinaus zu einer Seite des Tragbauteils (14a, 14b; 42; 52a, 52b) erstreckt und
der mindestens eine Teil des vorstehenden Abschnitts (26a, 26b, 27a, 27b, 28a, 28b, 29a, 29b, 32a, 32b, 34a, 34b; 62a, 62b) in Kontakt mit dem anderen von dem Substrat (12) und der Kippplatte (18; 46; 56) kommt, wenn die Kippplatte (18; 46; 56) geneigt wird.

2. MEMS-Vorrichtung (10; 30; 40; 50) nach Anspruch 1, bei der
der vorstehende Abschnitt (26a, 26b, 28a, 28b) ein Zungenstückabschnitt ist, der an der Kippplatte (18; 46; 56) ausgebildet ist und sich von einem Ende der Kippplatte (18; 46; 56) in einer Richtung senkrecht zu der Kippachse (X) nach außen erstreckt.

3. MEMS-Vorrichtung (10) nach Anspruch 2, bei der
die Kippplatte (18) zusätzlich zu dem Zungenstückabschnitt (26a, 26b, 28a, 28b) ferner mit einem vorstehenden Abschnitt (27a, 27b, 29a, 29b) ausgebildet ist, der sich von der Kippplatte (18) zu dem Substrat (12) erstreckt,
mindestens ein Teil des vorstehenden Abschnitts (27a, 27b, 29a, 29b) in der Ebene enthalten ist, die senkrecht zu der Kippachse (X) ist und den Verbindungsabschnitt (24a, 24b) der Kippplatte (18) und des Tragbalkens (16a, 16b) enthält, und
sowohl der mindestens eine Teil des Zungenstückabschnitts (26a, 26b, 28a, 28b) als auch der mindestens eine Teil des vorstehenden Abschnitts (27a, 27b, 29a, 29b) in Kontakt mit dem Substrat (12) kommen, wenn die Kippplatte (18) geneigt wird.

4. MEMS-Vorrichtung (60) nach Anspruch 1, bei der
der vorstehende Abschnitt (62a, 62b) ein an der Kippplatte (18) ausgebildeter vorstehender Abschnitt ist und sich von der Kippplatte (18) zu dem Substrat (12) erstreckt.

5. MEMS-Vorrichtung (30) nach Anspruch 1, bei der
der vorstehende Abschnitt (32a, 32b, 34a, 34b) ein vorstehender Abschnitt ist, der an dem Substrat (12) ausgebildet ist und sich von dem Substrat (12) zu der Kippplatte (18) erstreckt.

6. MEMS-Vorrichtung (10; 30; 40; 50; 60) nach einem der Ansprüche 1 bis 5, bei der die Kippplatte (18; 46; 56) einen aus unterschiedlichen Materialien hergestellten Schichtaufbau aufweist.

7. MEMS-Vorrichtung (10; 30; 40; 50; 60) nach einem der Ansprüche 1 bis 6, bei der die Kippplatte (18; 46; 56) mit einer solchen Form ausgebildet ist, dass eine Länge in einer Richtung längs der Kippachse (X) länger ist als eine Länge in einer Richtung, die senkrecht zu der Kippachse (X) ist.

8. MEMS-Vorrichtung (10; 30; 40; 50; 60) nach einem der Ansprüche 1 bis 7, bei der die Kippplatte (18; 46; 56) einen Reflexionsabschnitt aufweist.

9. MEMS-Vorrichtung (10; 30; 40; 50; 60) nach Anspruch 8, bei der der Reflexionsabschnitt ein Spiegel ist, der dazu in der Lage ist, eine elektromagnetische Welle zu reflektieren.

## Revendications

1. Dispositif MEMS (10 ; 30 ; 40 ; 50 ; 60) comprenant :
un substrat (12) ;
une plaque d'inclinaison (18 ; 46 ; 56) agencée à un intervalle par rapport au substrat (12) ;
un élément de support (14a, 14b ; 42 ; 52a, 52b) fixé au substrat (12) ; et
une poutre de support (16a, 16b ; 44a, 44b ; 54a, 54b) ayant une première extrémité reliée à l'élément de support (14a, 14b ; 42 ; 52a, 52b) et une seconde extrémité reliée à la plaque d'inclinaison (18 ; 46 ; 56), et supportant de manière inclinée la plaque d'inclinaison (18 ; 46 ; 56) autour d'un axe d'inclinaison (X), dans lequel un élément parmi le substrat (12) et la plaque d'inclinaison (18 ; 46 ; 56) est pourvu d'une portion saillante (26a, 26b, 27a, 27b, 28a, 28b, 29a, 29b, 32a, 32b, 34a, 34b ; 62a, 62b),
au moins une partie de la portion saillante (26a, 26b, 27a, 27b, 28a, 28b, 29a, 29b, 32a, 32b, 34a, 34b ; 62a, 62b) est incluse dans un plan perpendiculaire à l'axe d'inclinaison (X) et comprend une portion de liaison (24a, 24b ; 48a, 48b ; 58a, 58b) de la plaque d'inclinaison (18 ; 46 ; 56) et de la poutre de support (16a, 16b ; 44a, 44b ; 54a, 54b),
par rapport à une direction le long de l'axe d'inclinaison (X), une portion d'extrémité latérale de la plaque d'inclinaison (18 ; 46 ; 56) s'étend au-delà de la portion de liaison (24a, 24b ; 48a, 48b ; 58a, 58b) de la plaque d'inclinaison (18 ; 46 ; 56) et de la poutre de support (16a, 16b ; 44a, 44b ; 54a, 54b) jusqu'à un côté d'élément de support (14a, 14b ; 42 ; 52a, 52b), et
l'au moins une partie de la portion saillante (26a, 26b, 27a, 27b, 28a, 28b, 29a, 29b, 32a, 32b, 34a, 34b ; 62a, 62b) entre en contact avec l'autre élément parmi le substrat (12) et la plaque d'inclinaison (18 ; 46 ; 56), quand la plaque d'inclinaison (18 ; 46 ; 56) s'incline.

2. Dispositif MEMS (10 ; 30 ; 40 ; 50) selon la revendication 1, dans lequel
la portion saillante (26a, 26b, 28a, 28b) est une portion de pièce languette formée sur la plaque d'inclinaison (18 ; 46 ; 56) et s'étendant dans une direction perpendiculaire à l'axe d'inclinaison (X) depuis une extrémité de la plaque d'inclinaison (18 ; 46 ; 56) vers l'extérieur.

3. Dispositif MEMS (10) selon la revendication 2, dans lequel
la plaque d'inclinaison (18) est en outre pourvue d'une portion de projection (27a, 27b, 29a, 29b) s'étendant depuis la plaque d'inclinaison (18) vers le substrat (12), en plus de la portion de pièce languette (26a, 26b, 28a, 28b),
au moins une partie de la portion de projection (27a, 27b, 29a, 29b) est incluse dans le plan perpendiculaire à l'axe d'inclinaison (X) et comprend la portion de liaison (24a, 24b) de la plaque d'inclinaison (18) et de la poutre de support (16a, 16b), et
l'au moins une partie de la portion de pièce languette (26a, 26b, 28a, 28b) et l'au moins une partie de la portion de projection (27a, 27b, 29a, 29b) entrent toutes les deux en contact avec le substrat (12), quand la plaque d'inclinaison (18) s'incline.

4. Dispositif MEMS (60) selon la revendication 1, dans lequel la portion saillante (62a, 62b) est une portion de projection formée sur la plaque d'inclinaison (18) et s'étendant depuis la plaque d'inclinaison (18) vers le substrat (12).

5. Dispositif MEMS (30) selon la revendication 1, dans lequel la portion saillante (32a, 32b, 34a, 34b) est une portion de projection formée sur le substrat (12) et s'étendant depuis le substrat (12) vers la plaque d'inclinaison (18).

6. Dispositif MEMS (10 ; 30 ; 40 ; 50 ; 60) selon l'une quelconque des revendications 1 à 5, dans lequel la plaque d'inclinaison (18 ; 46 ; 56) a une structure stratifiée composée de différents matériaux.

7. Dispositif MEMS (10 ; 30 ; 40 ; 50 ; 60) selon l'une quelconque des revendications 1 à 6, dans lequel la plaque d'inclinaison (18 ; 46 ; 56) est formée d'une telle forme qu'une longueur dans une direction le long de l'axe d'inclinaison (X) est supérieure à une longueur dans une direction perpendiculaire à l'axe d'inclinaison (X).

8. Dispositif MEMS (10 ; 30 ; 40 ; 50 ; 60) selon l'une quelconque des revendications 1 à 7, dans lequel la plaque d'inclinaison (18 ; 46 ; 56) a une portion réfléchissante.

9. Dispositif MEMS (10 ; 30 ; 40 ; 50 ; 60) selon la revendication 8, dans lequel la portion réfléchissante est un miroir pouvant réfléchir une onde électromagnétique.
